# EUROPEAN PATENT SPECIFICATION

(11) **EP 4 397 158 B1**
(45) Date of publication and mention of the grant of the patent: **11.11.2026**
(21) Application number: 21770209.1
(22) Date of filing: 01.09.2021
(51) Int. Cl.: H10N 60/10, H10N 60/01

(54) **SEMICONDUCTOR-SUPERCONDUCTOR HYBRID DEVICE HAVING A TUNNEL BARRIER AND ASSOCIATED FABRICATION AND OPERATING METHODS**
HALBLEITER-SUPRALEITER-HYBRIDBAUELEMENT MIT EINER TUNNELBARRIERE SOWIE ZUGEHÖRIGE HERSTELLUNGS- UND BETRIEBSVERFAHREN
DISPOSITIF HYBRIDE SEMICONDUCTEUR-SUPRACONDUCTEUR AYANT UNE BARRIÈRE TUNNEL ET PROCÉDÉS DE FABRICATION ET DE FONCTIONNEMENT ASSOCIÉS

(43) Date of publication of application: 10.07.2024
(73) Proprietor: Microsoft Technology Licensing, LLC, Redmond, WA 98052-6399 (US)
(72) Inventor: LEVAJAC, Vukan, Redmond, Washington 98052-6399 (US); LEMANG, Mathilde, Flore, Redmond, Washington 98052-6399 (US); KOUWENHOVEN, Leonardus, Petrus, Redmond, Washington 98052-6399 (US); WANG, Jiyin, Redmond, Washington 98052-6399 (US)
(74) Representative: Page White Farrer
(86) International application number: PCT/EP2021/074183
(87) International publication number: WO 2023/030626

(56) References cited:
- WO-A1-2019/074557
- US-A1- 2021 126 181
- MASTOMÄKI J ET AL: "InAs nanowire superconducting tunnel junctions: Quasiparticle spectroscopy, thermometry, and nanorefrigeration", NANO RESEARCH, vol. 10, 13 June 2017 (2017-06-13), pages 3468 - 3475, XP036316393, DOI: 10.1007/S12274-017-1558-7
- BORSOI F ET AL: "Single-Shot Fabrication of Semiconducting-Superconducting Nanowire Devices", ADVANCED FUNCTIONAL MATERIALS, vol. 31, 2102388, 17 June 2021 (2021-06-17), XP055925059, DOI: 10.1002/adfm.202102388
- GRIVNIN A ET AL: "Concomitant opening of a bulk-gap with an emerging possible Majorana zero mode", NATURE COMMUNICATIONS, vol. 10, 1940, 29 April 2019 (2019-04-29), XP055925086, DOI: 10.1038/s41467-019-09771-0

## Description

### Background

Semiconductor nanowires proximitized by a superconductor are expected to host a topological phase of matter, provided the right conditions. This makes them a promising candidate as building blocks of a fault-tolerant quantum computer.

The topological phase manifests itself in the form of a pair of Majorana zero modes ("MZMs") at the ends of the nanowire. Along the bulk of the wire, away from the ends, a gap in the single-electron spectrum is present. Experiments typically use tunneling spectroscopy at the ends of the nanowire to detect a zero-bias peak ("ZBP") in tunneling conductance.

By forming a network of such nanowires and inducing the topological regime in parts of the network, it is possible to create a quantum bit which can be manipulated for the purpose of quantum computing. A quantum bit, also referred to as a qubit, is an element upon which a measurement with two possible outcomes can be performed, but which at any given time (when not being measured) can in fact be in a quantum superposition of the two states corresponding to the different outcomes.

A nanowire may take the form of an elongate portion of semiconductor material, having a length dimension many times greater than its width and thickness. A nanowire is a quasi-one-dimensional system. A layer of conventional superconductor is arranged on at least a portion of the nanowire.

Another system useful for generating MZMs is a semiconductor nanowire based on a two-dimensional electron gas ("2DEG") with proximity coupling to a conventional superconductor. The superconductor is typically grown as part of an epitaxial 2D wafer stack but can also be deposited after material growth during fabrication. This material platform has sizable spin-orbit coupling and large electron g-factor, which are key ingredients for the formation of a topological state. The 2D platform allows complex device geometries via top-down lithographic patterning involving etching and deposition.

To induce a topological phase, the device is cooled to a temperature where the superconductor (e.g. aluminum) exhibits superconducting behavior. The superconductor causes a proximity effect in the adjacent semiconductor, whereby a region of the semiconductor near the interface with the superconductor also exhibits superconducting properties, that is, a superconducting pairing gap is induced in the adjacent semiconductor. MZMs are formed at two ends of the semiconductor-superconductor hybrid when a magnetic field is applied.

The role of the magnetic field is to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The Zeeman energy, i.e. the magnitude of the energy level split, should be at least as large as the superconducting gap in order to close the trivial superconducting gap and reopen a topological gap in the system.

Inducing MZMs may also involve adjusting the electrostatic potential of charge carriers in the nanowire by gating the nanowire with an electrostatic potential. The electrostatic potential is applied using a gate electrode. Applying an electrostatic potential manipulates the number of charge carriers in the conductance band or valence band of the semiconductor component.

There is a need to measure the electronic properties of semiconductor-superconductor hybrid systems. One technique used to conduct such measurements is tunnelling spectroscopy. To perform a tunnelling spectroscopy measurement, a conductive lead is arranged near a semiconductor-superconductor hybrid structure. A tunnelling current flows between the semiconductor-superconductor hybrid structure and the conductive lead. Properties of the current (e.g., its magnitude, frequency, phase) are measured. Information about the properties of the semiconductor-superconductor hybrid structure can be inferred based on such measurements.

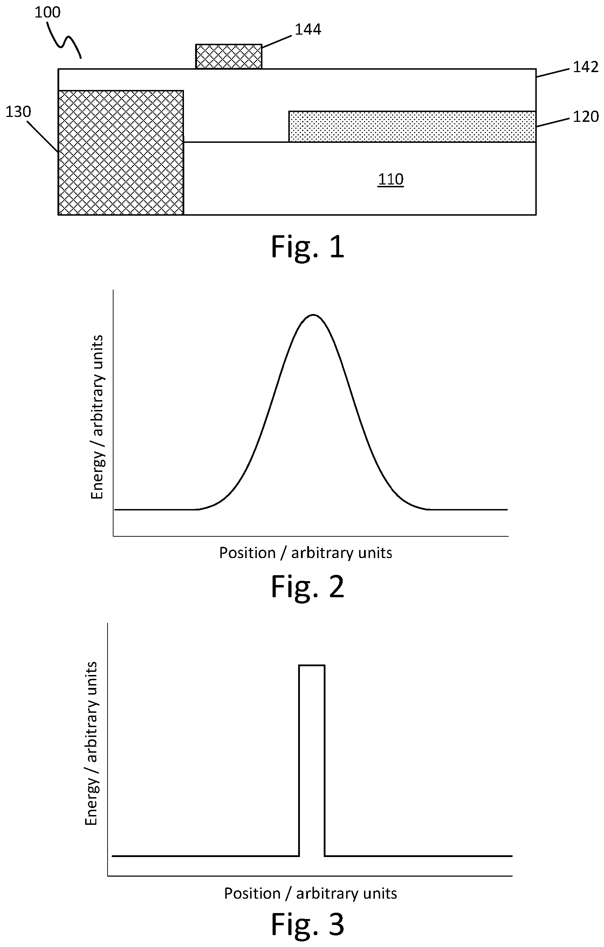

Fig. 1 shows a typical system 100 for performing tunnelling spectroscopy measurements. The system includes a semiconductor component 110 in the form of a nanowire. A superconductor component 120 is arranged on the semiconductor component. A normally-conductive lead 130 is arranged at an end of the semiconductor nanowire 110. The superconductor component does not extend to the end of the nanowire 110, and is spaced from the normally-conductive lead by a space. A gate stack comprising gate dielectric 142 and gate electrode 144 is arranged over the semiconductor nanowire 110. The gate electrode 114 is configured to gate the semiconductor material in the space. Applying an electrostatic field to the gate electrode creates a tunnel barrier between the semiconductor-superconductor hybrid portion of the device and the normally-conductive lead. The tunnel barrier is created inside the semiconductor component 110: part of the semiconductor is caused to act as a tunnel barrier.

Mastomäki et al (Nano Research, vol. 10, no. 10, pp. 3468-3475) discloses a method for creating tunnel junctions between superconducting aluminium reservoirs and InAs semiconductor nanowires. The method is based on controlled oxidation.

Borsoi et al (Advanced Functional Materials, vol. 31, 2102388) discloses fabrication of semiconductor-superconductor nanowire devices. The method uses shadow walls to enable the *in situ,* selective, and consecutive depositions of superconductors and normal metals to form normal-superconducting junctions.

Grivnin et al (Nature Communications, vol. 10, 1940) discloses simultaneous probing of bulk and edge states of a 1D InAs nanowire coated with epitaxial aluminium for the identification of Majorana edge states.

US 2021/0126181 A1 discloses a semiconductor-superconductor hybrid device comprising a semiconductor, a superconductor, and a barrier between the superconductor and the semiconductor. The device is configured to enable energy level hybridisation between the semiconductor and the superconductor. The barrier is configured to increase a topological gap of the device. The barrier allows for control over the degree of hybridisation between the semiconductor and the superconductor.

WO 2019/074557 A1 discloses a method for fabricating a quantum device, the method comprising: providing a substrate and an insulator formed on the substrate; from combinations of selective-area-grown semiconductor material along with regions of a superconducting material, forming a network of nanowires oriented in a plane of the substrate which can be used to produce a Majorana-based topological qubit; and fabricating a side gate for controlling a topological segment of the qubit. The selective-area-grown semiconductor material is grown on the substrate by etching trenches in the insulator formed on the substrate to define the nanowires and depositing the semiconductor material in the trenches defining the nanowires. Fabricating the side gate comprises etching the dielectric to create a trench for the side gate and depositing the side gate in the trench.

### Summary

In one aspect, there is provided a device according to claim 1, comprising: a semiconductor-superconductor hybrid structure comprising a semiconductor component and a superconductor component, the superconductor component comprising a layer of aluminium; at least one conductive lead in tunnelling communication with the semiconductor-superconductor hybrid structure; and a tunnel barrier arranged between the semiconductor-superconductor hybrid structure and the at least one conductive lead. The conductive lead is arranged over the superconductor component such that the superconductor component shields the semiconductor component from the conductive lead. The tunnel barrier is arranged between the superconductor component and the at least one conductive lead. The tunnel barrier consists of a native aluminium oxide layer formed integrally to the superconductor component. Since the superconductor component is arranged between the conductive lead and the semiconductor component, the superconductor component may screen high-energy electrons, thereby allowing low-energy electrons (e.g., those corresponding to MZMs) to be detected more easily. Forming the tunnel barrier integrally to the superconductor component provides a high-quality dielectric barrier between the conductive lead and the semiconductor-superconductor hybrid structure.

In another aspect, there is provided a method of fabricating a device, according to claim 9.

In a still further aspect, there is provided a method of operating the device of the invention, as defined in claim 15. The method comprises: cooling the device to a temperature below the critical temperature of the superconductor component such that the superconductor component displays superconductivity; applying a magnetic field to the semiconductor-superconductor hybrid structure; electrostatically gating the semiconductor-superconductor hybrid structure; and measuring a tunnelling current through the at least one conductive lead.

### Brief Description of the Drawings

To assist understanding of embodiments of the present invention and to show how such embodiments may be put into effect, reference is made, by way of example only, to the accompanying drawings in which:
Fig. 1 is a schematic cross-section of a device according to a comparative example;
Fig. 2 is an illustration of electrical potential as a function of position at a junction in the device of the comparative example;
Fig. 3 is an illustration of electrical potential as a function of position at an ideal junction;
Fig. 4 is a schematic cross-section along the length of an example device according to an embodiment of the invention;
Fig. 5 is a cross-section along line A of Fig. 4;
Fig. 6 is a flow chart of a method for fabricating a device of the invention;
Fig. 7 is a schematic perspective view of a shadow wall useful in the fabrication of an example device;
Fig. 8 is a plan view of an arrangement of shadow walls useful for fabricating a device having two terminals;
Fig. 9 is a plan view of an arrangement of shadow walls useful for fabricating a device having three terminals; and
Fig. 10 is a plan view of an arrangement of shadow walls useful for fabricating a device having a conductive lead at each end of a nanowire, and a conductive lead in communication with a bulk region of the nanowire;
Fig. 11 is a flowchart of a method of operating a device of the invention.

### Detailed Description

As used herein, the verb 'to comprise' is used as shorthand for 'to include or to consist of'. In other words, although the verb 'to comprise' is intended to be an open term, the replacement of this term with the closed term 'to consist of' is explicitly contemplated, particularly where used in connection with chemical compositions.

Directional terms such as "top", "bottom", "left", "right", "above", "below", "horizontal" and "vertical" are used herein for convenience of description and relate to the orientation shown in the relevant drawing. The substrate is taken to be the "bottom" of the device. For the avoidance of any doubt, this terminology is not intended to limit the orientation of the device in an external frame of reference.

As used herein, the terms "superconductor component" and "superconductive metal" refer respectively to components and metals which become superconductive when cooled to a temperature below a critical temperature, T_{c}, of the material. The use of these terms is not intended to limit the temperature of the device when not in use.

A "nanowire" is an elongate member having a nano-scale width, and a length-to-width ratio of at least 100, or at least 500, or at least 1000. A nanowire may have a width in the range 10 to 500 nm, optionally 50 to 100 nm or 75 to 125 nm. Lengths are typically of the order of micrometres, e.g. at least 1 µm, or at least 10 µm. In particular, a nanowire may have a diameter in the range 80 to 100 nm, and a length in the range 10 to 15 µm.

A "semiconductor-superconductor hybrid structure" comprises a semiconductor component and a superconductor component which are configured such that, under appropriate operating conditions, the superconductor component induces superconductivity in the semiconductor component by proximity effect. In particular, this term refers to a structure capable of showing topological behaviour such as Majorana zero modes, or other excitations useful for quantum computing applications. The operating conditions generally comprise cooling the structure to a temperature below the Tc of the superconductor component, applying a magnetic field to the structure, and applying electrostatic gating to at least a portion of the structure. Generally, at least part of the semiconductor component is in intimate contact with the superconductor component, for example the superconductor component may be epitaxially grown on the semiconductor component. Certain device structures having one or more further components between the semiconductor component and superconductor component have however been proposed.

A "directional deposition process" is a process that uses a directed beam of material or a precursor of the material to deposit material on a surface. In a directional deposition process, the position at which material is adsorbed onto the surface is determined by the direction of the beam. The beam has a constant azimuth relative to the surface, or in other words, the direction of the beam relative to the surface is fixed during the deposition. Examples of processes which may be used to achieve directional deposition include molecular beam epitaxy, thermal evaporation, and electron beam evaporation.

It has been found that devices of the type shown in Fig. 1 may not allow the reliable detection of Majorana zero modes. This is because trivial states which have signatures that mimic Majorana zero modes may be induced in such devices. For example, Andreev states may be induced at the tunnel junctions in the comparative device.

In the comparative device, the tunnel junction is defined electrostatically. This may cause the junction to have a non-uniform, or smooth, electrostatic potential profile, as illustrated in Fig. 2. A non-uniform potential profile may generate "quasi-Majoranas": trivial states that reduce the visibility of true MZMs. This effect has been described by Vuik et al. SciPost Phys. 7, 061 (2019).

It would be desirable to provide a device having a tunnel barrier with a sharp electrostatic potential profile, as illustrated in Fig. 3. Provided herein are devices having tunnel junctions which may be associated with fewer trivial states, and/or which may allow for the easier detection of MZMs.

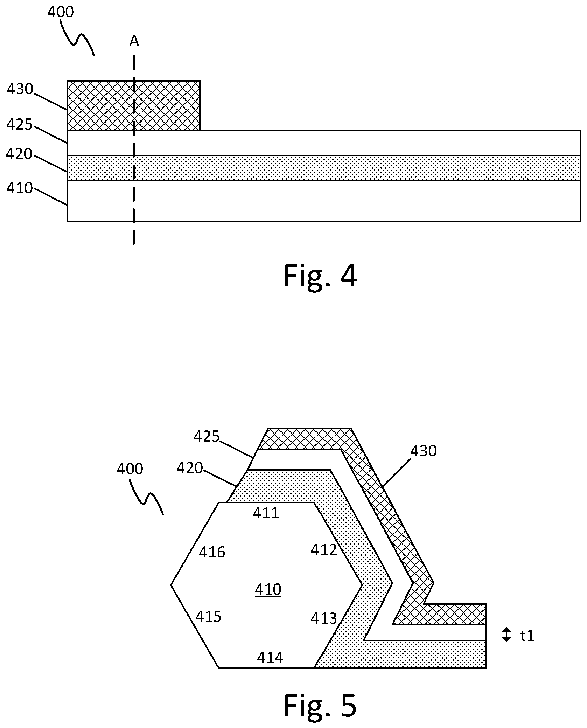

An example device 400 will now be described with reference to Figs. 4 and 5. Fig. 4 is a schematic cross-section taken along the length of the device. Fig. 5 is a schematic cross-section taken along line A of Fig. 4.

The device 400 includes a semiconductor-superconductor hybrid structure, a tunnel barrier arranged on the semiconductor-superconductor hybrid structure, and a conductive lead arranged on the tunnel barrier at one end of the semiconductor-superconductor hybrid structure.

The device may be arranged on a substrate. The substrate typically comprises a wafer, i.e. a piece of single crystalline material. One example wafer material is indium phosphide. Other examples of wafer materials include gallium arsenide, indium antimonide, indium arsenide, and silicon. The substrate may be a more elaborate workpiece, further comprising additional structures arranged on or over the wafer. The substrate may include layers of two or more materials. An example of a multi-layer substrate is a silicon-on-insulator substrate, in particular a silicon-on-insulator substrate obtainable by the smart cut process.

The semiconductor-superconductor hybrid structure comprises a semiconductor component 410 and a superconductor component 420. The superconductor component 420 is configured to induce superconductivity in the semiconductor component 410 by proximity effect. Under appropriate conditions, this may induce useful excitations, such as Majorana zero modes, in the hybrid structure.

The semiconductor component may be implemented in various ways. In this example, the semiconductor component 410 is in the form of a nanowire. Semiconductor nanowires may be fabricated by, for example, selective area growth ("SAG") or vapour-liquid-solid ("VLS") processes. Techniques for selective area growth are disclosed in *e.g.,* Davies Proc. SPIE 2140, Epitaxial Growth Processes, 58 (doi:10.1117/12.175795); Fahed, Doctoral thesis: Selective area growth of in-plane III-V nanostructures using molecular beam epitaxy, 2016 (http://www.theses.fr/2016LIL10114); Fukui et al, Appl. Phys. Lett. 58, 2018 (1991) (doi: 10.1063/1.105026); and Aseev et al. Nano Letters 2019 19 (1), 218-227, doi: 10.1021/acs.nanolett.8b03733.

A variety of semiconductor materials are useful for the fabrication of semiconductor nanowires. One illustrative class of semiconductor materials is the III-V semiconductors. The semiconductor component 410 may for example comprise a material of Formula 1:

InAsₓSb₁₋ₓ (Formula 1)

where x is in the range 0 to 1. In other words, the semiconductor component 410 may comprise indium antimonide (x=0), indium arsenide (x=1), or a ternary mixture comprising 50 % indium on a molar basis and variable proportions of arsenic and antimony (0 < x < 1).

The illustrated nanowire 410 is a VLS nanowire having six crystal faces or facets 411, 412, 413, 414, 415, 416. In this example, the superconductor component 420, tunnel barrier 425, and conductive lead 430 are arranged on a subset of the facets. The subset comprises a top facet 411 and two facets 412, 413 on one side of the nanowire 410. The superconductor component, tunnel barrier, and conductive lead do not extend over the opposite side of the nanowire comprising facets 415 and 416. Bottom facet 414 is in contact with a substrate. In implementations where the superconductor component 420 is fabricated by directional deposition of superconductor material, one side of the nanowire may be shadowed and may not receive superconductor material.

The superconductor component 420, tunnel barrier 425, and conductive lead 430 may have different thicknesses. The thicknesses of the superconductor component 420, tunnel barrier 425, and conductive lead 430 may vary between different facets. For example, the thickness of the part of superconductor component 420 on facet 411 may be different from the thickness of the part on facet 412.

The superconductor component 420 comprises a layer of superconducting metal, the superconducting metal being aluminium. The use of aluminium allows a tunnel barrier in the form of a native aluminium oxide layer to be formed *in situ* oxidation. The superconductor component may have a thickness in the range 4 to 10 nm.

The superconductor component 420 may be an island of superconductor material, not electrically connected to a further component. A device which includes a superconductor component in the form of an island may be useful as a component of a topological qubit. Alternatively, the superconductor component 420 may be connected to electrical ground. Connecting the superconductor component 420 to ground may be useful for allowing tunnelling spectroscopy measurements to be performed on the semiconductor-superconductor hybrid structure. In a tunnelling spectroscopy measurement, superconductor component 420 is grounded, voltage is applied to a conductive lead 430, and current through the conductive lead is measured.

Arranged on the superconductor components 420 is tunnel barrier 425. A conductive lead 430 is arranged on the tunnel barrier 425.

Conductive lead 430 is an electrode which is typically configured to act as a normal conductor when in use. The conductive lead may be fabricated from a normally-conductive metal such as platinum, silver, or gold. Superconductor metals may alternatively be used, particularly when the conductive lead extends perpendicular to the superconductor component of the semiconductor-superconductor hybrid structure: superconductor materials may show anisotropy of critical magnetic field, and may display either normally-conductive or superconductive behaviour depending on their orientation with respect to an applied magnetic field.

In operation, the conductive lead 430 may be used to perform tunnelling spectroscopy measurements on the semiconductor-superconductor hybrid structure. To this end, conductive lead 430 may be connected to an amplifier circuit. The amplifier circuit may be arranged on the same substrate as the device, or a different substrate. The connection may by any suitable arrangement of transmission lines, contact pads, wire bonds, and/or the like.

Conductive lead 430 extends only over portions of the semiconductor component which are also covered by the superconductor component 420. This may prevent the conductive lead 430 from disturbing chemical potentials in the semiconductor-superconductor hybrid device, since superconductor components are capable of selectively screening electrons which have energies above a certain limit, as will be explained further below.

Tunnel barrier 425 is a dielectric layer which allows for the tunnelling of electrons between the semiconductor-superconductor hybrid structure and the conductive lead.

It is been found that the tunnelling of electrons from the semiconductor component to the conductive lead through the superconductor component is possible. The states of interest, e.g. Majorana zero modes, are isolated states which reside below the superconducting gap. A superconductor component has no states which are below the superconducting gap. Usefully, at the same time, the superconductor component shields the semiconductor-superconductor hybrid structure from electric fields induced by the conductive lead.

The tunnel barrier is a dielectric, and has no states in the low energy range. The tunnel barrier does not therefore interfere with the signal from the semiconductor-superconductor hybrid structure.

Electrons which are in topological states are able to tunnel through the superconductor and the tunnel barrier because the maximum coherence length of these electrons is greater than the thickness of the superconductor component and the tunnel barrier. The maximum coherence length ξ in a bulk superconductor is calculated in accordance with Equation 1: ${ξ}_{BULK} = \frac{{ℏυ}_{f}}{πΔ}$ where h is the reduced Planck constant, u_{f} is the Fermi velocity, and Δ is the induced superconducting energy gap of the hybrid system.

Constraining electrons to a 1-dimensional system, e.g. a nanowire, or a 2-dimensional system such as a 2DEG, changes the maximum coherence length. The maximum coherence length in such a system may be approximated by Equation 2: ${ξ}_{CONSTRAINED} = \sqrt{{ξ}_{BULK} ∗ {l}_{m}}$ where Iₘ is the mean free path of electrons in the dimensionally constrained system.

The total thickness of the superconductor component and the tunnel barrier is selected to be less than the maximum coherence length of the excitations of interest. In practice, this constraint is not particularly limiting. It has been reported that trivial subgap states may have coherence lengths of up to about 300 nm (Menard, et al., PRL 124, 036802 (2020)). It is theorized that Majorana zero modes could have coherence lengths of up to 1 µm or even greater in some devices. These coherence lengths are substantially larger than the typical thicknesses of the superconductor component 420 and tunnel barrier 425. By way of illustration, superconductor components of hybrid devices generally have a thickness of less than or equal to 15 nm. The tunnel barrier generally has a thickness in the range 1 to 4 nm.

The conductive lead 430 extends only over portions of the semiconductor component 410 which are covered by the superconductor component 420. This reduces the effects of the conductive lead 430 on chemical potential in the semiconductor component 410, since the superconductor component shields the hybrid portion of the device from the electric field induced by the conductive lead.

The shielding effect may be particularly advantageous in implementations where the conductive lead is in tunnelling communication with a bulk segment of the nanowire, in other words a segment which is not at an end of the nanowire. In a comparative example having an unshielded conductive lead in communication with the bulk, the lead may disrupt the topological phase. An unshielded lead may perturb the chemical potential in the nanowire by an amount which is greater than the topological gap. By way of illustration, the maximum topological gap in a hybrid structure comprising aluminium and indium antimonide is about 250 µeV.

The conductive lead 430 does not extend over portions of the nanowire which are not provided with superconductor component.

Since the tunnel barrier is not defined electrostatically, the potential at the tunnel junction is sharper, approaching the idealised potential illustrated in Fig. 3. This may avoid the creation of quasi-MZMs, thereby allowing true MZMs to be detected more easily.

Tunnel barrier 425 is formed integrally to the superconductor component 420. The superconductor component 420 comprises aluminium, and the tunnel barrier 425 consists of a native aluminium oxide layer formed on the aluminium. Such a layer may be formed by exposing the aluminium to oxygen gas. The thickness of the native oxide layer may be controlled by varying the pressure of the oxygen gas. For example, the portion of the tunnel barrier which is under the at least one conductive lead may have a thickness t1 in the range 1 to 2 nm.

By forming the tunnel barrier *in situ* integrally to the superconductor component, without the use of deposition, a higher quality tunnel barrier may be obtained. A tunnel barrier which consists of native aluminium oxide has been found to perform better than a barrier which includes a deposited layer of dielectric material, such as an evaporated aluminium oxide layer. Forming the aluminium oxide *in situ* may avoid contamination of the dielectric layer. Forming the aluminium oxide layer *in situ* may allow for more precise control over the thickness of the aluminium layer. A native aluminium oxide layer may have fewer trapped charges than an evaporated aluminium oxide layer.

Various modifications may be made to the illustrated device.

The example device 400 has a single conductive lead at one end of the semiconductor-superconductor hybrid structure. In variants, any number of leads may be present.

For example, a pair of conductive leads may be provided at respective ends of the semiconductor-superconductor hybrid structure. Majorana zero modes exist in pairs, at opposite ends of the hybrid structure, and providing leads at each end may therefore be useful for detecting Majorana zero modes.

Alternatively or additionally, a conductive lead may be arranged over a bulk portion of the semiconductor-superconductor hybrid structure, i.e. a portion which is spaced from the ends of the hybrid structure. When Majorana zero modes are formed, a topological phase transition occurs: the superconducting gap in the bulk closes and then reopens. The ability to perform tunnelling spectroscopy measurements on the bulk of the nanowire may therefore allow Majorana zero modes to be detected.

An example device configuration includes a conductive lead at each end of the semiconductor-superconductor hybrid structure, and one or more conductive leads arranged over bulk portions of the semiconductor-superconductor hybrid structure. By arranging the conductive lead such that the superconductor component shields the hybrid structure from the conductive lead, disruption of the topological phase may be avoided even when the conductive lead extends over a bulk portion.

The example device includes a semiconductor nanowire, which is depicted as a VLS nanowire. A SAG nanowire may alternatively be used.

The principles described herein may be applied to any type of semiconductor-superconductor hybrid system. The semiconductor component is not necessarily in the form of a nanowire. The semiconductor component may alternatively be in the form of a semiconductor heterostructure configured to host a two-dimensional electron gas ("2DEG") or a two-dimensional hole gas ("2DHG").

The semiconductor heterostructure may comprise a quantum well arranged between a lower barrier and an upper barrier. The quantum well comprises a material which is different from the material(s) of the lower barrier and upper barrier. The materials of the lower barrier layer and the upper barrier layer may each be independently selected.

The lower and upper barriers serve to trap charge carriers in the quantum well. The quantum well layer may comprise a layer of semiconductor material which has a relatively small band gap compared to the materials of the lower and upper barriers. Illustrative materials useful for forming quantum wells are described in, for example, Odoh and Njapba, "A Review of Semiconductor Quantum Well Devices", Advances in Physics Theories and Applications, vol. 46, 2015, pp. 26-32; and S. Kasap, P. Capper (Eds.), "Springer Handbook of Electronic and Photonic Materials", DOI 10.1007/978-3-319-48933-9_40.

Semiconductor-superconductor hybrid devices may include a gate stack for gating one or more portions of the semiconductor-superconductor hybrid structure. Electrostatic gating is useful for tuning the behaviour of hybrid structures. Any number of gate electrodes may be included.

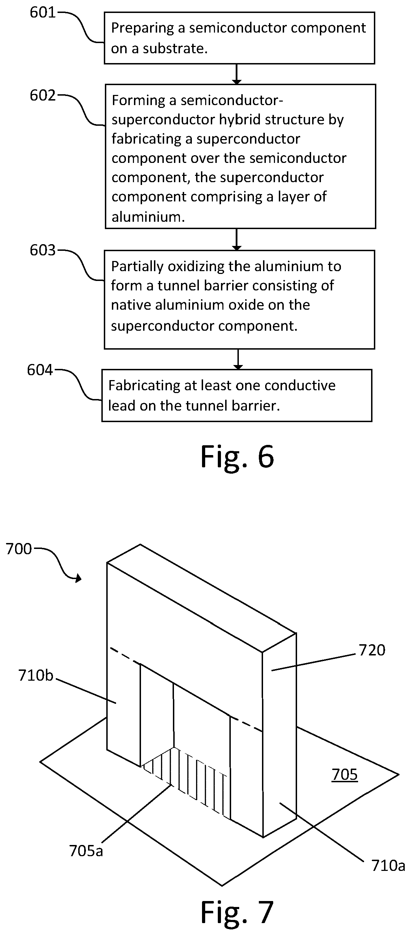

An example method of fabricating a device as described herein will now be described with reference to Fig. 6. Fig. 6 is a flow diagram outlining the method.

The device is fabricated on a substrate. The substrate may comprise a wafer, as described above. The substrate may be pre-patterned. In other words, one or more components selected from gate electrodes, contact pads, leads, isolation layers, and shadow walls may be provided on the substrate before forming the semiconductor-superconductor hybrid device.

At block 601, a semiconductor component is prepared on a substrate. Semiconductor components may be implemented in various ways. The process used to form the semiconductor component may be selected as appropriate.

One example process is selective area growth, SAG. SAG involves forming an amorphous mask over the substrate, and then growing the semiconductor component epitaxially on the substrate in openings in the mask. SAG is useful for fabricating horizontally orientated nanowires.

Another example process is the vapour liquid solid, VLS, process. VLS uses a droplet of liquid catalyst to control the growth of a nanowire on a growth substrate. VLS produces vertically orientated nanowires. VLS nanowires may optionally be cleaved from the growth substrate and then arranged horizontally, either on the growth substrate or a different substrate.

A still further possibility is to grow semiconductor epitaxially over the entire surface of the substrate. A plurality of layers, each comprising an independently selected material, may be built up in this way. This approach is useful for the fabrication of 2DEG structures.

At block 602, a semiconductor-superconductor hybrid structure is formed by fabricating a superconductor component over the semiconductor component. The superconductor component comprises a layer of superconductive metal.

Various processes may be used to fabricate superconductor components. For example, superconductor material may be deposited globally, over the entire surface of the substrate, and then patterned lithographically or by lift-off. Lithographic processes and lift-off processes include etching steps.

It is generally desirable to avoid the use of etching. Etching may damage the semiconductor component and/or degrade the interface between the semiconductor and superconductor, which may it more difficult to induce or observe excitations such as MZMs.

The use of etching may be avoided by depositing material selectively onto target regions. This may be achieved by the use of directional deposition controlled by shadow walls. A directional deposition process involves directing a beam of material toward a target substrate from a particular direction with respect to the substrate. A shadow wall is a structure which is configured to block the path of the beam, thereby creating a shadow region in which that material is not deposited. Various examples of shadow walls have been described in WO2019/099171 A2, US 10,629,798; US2020/0243742 A1; and WO2021/112856 A1. The shape of the shadow region may be controlled by selecting the shape of the shadow wall and the direction from which the beam of material is deposited.

In implementations where shadow walls are used, the shadow walls may be formed on the substrate before or after preparing the semiconductor component.

At block 603, the superconductive metal is reacted with a reagent, to form a tunnel barrier. This operation converts part of the layer of superconductor material deposited at block 602 into a dielectric layer.

Since the superconductive metal is aluminium, this operation may comprise exposing the aluminium metal to a gas comprising dioxygen, ozone, or a mixture thereof. By controlling the pressure of the gas, the thickness of the tunnel barrier may be adjusted.

Forming the tunnel barrier does not comprise depositing additional dielectric material onto the substrate. The tunnel barrier is formed *in situ* by converting part of the superconductor into a dielectric, i.e., converting part of an aluminium layer into a native aluminium oxide layer.

At block 604, at least one conductive lead is fabricated on the tunnel barrier. The conductive lead is arranged such that the superconductor component shields the semiconductor component from the conductive lead. In other words, the conductive lead does not extend over parts of the semiconductor component which are not covered by the superconductor component.

The process used to fabricate the conductive lead may be selected as appropriate. Various techniques for fabricating metal electrodes are known.

In particular, the conductive lead may be fabricated using directional deposition controlled by the use of shadow walls. Usefully, in implementations where the superconductive component is fabricated through the use of shadow walls, the same shadow walls may be used to control both the fabrication of the superconductor component and the fabrication of the conductive lead. The superconductor component and conductive lead may be deposited from different angles, such that the conductive lead is applied only over selected parts of the superconductor component.

After fabrication, a protective layer of a dielectric such as hafnium oxide may be applied over the device. Gate electrodes may be fabricated on the protective layer as desired.

Alternatively, gate electrodes and a gate dielectric may be incorporated into the substrate before the operations of block 601. This results in a bottom-gated device. Pre-patterning the gate electrodes minimizes the fabrication steps performed after fabricating the superconductor component. This may allow a pristine semiconductor-superconductor interface to be obtained. A high-quality interface may allow Majorana zero modes to be obtained more reliably.

The method may be performed in a sealed apparatus, for example comprising a vacuum chamber and an oxidation chamber connected to the vacuum chamber. The oxidation chamber may be a load-lock for the vacuum chamber. The method may be performed without removing the device from the apparatus, in other words, without exposing the device to the open atmosphere. Avoiding exposure to e.g. water vapour may prevent damage to surfaces of the material layers.

The method may be free of the use of etching, e.g., ion milling or wet etching. Avoiding etching may avoid damage to materials or material boundaries.

As discussed above, the superconductor component and conductive lead are preferably fabricated by directional deposition controlled by shadow walls. One illustrative example of a shadow wall 700 is shown in Fig. 7.

The example shadow wall 700 comprises two supporting portions 710a, 710b and a hanging portion 720. The supporting portion 710a, 710b are each in the form of pillars. Hanging portion 720 bridges the pillars 710a, 710b. Hanging portion 720 overhangs region 705a of substrate 705, in other words there is a space between hanging portion 720 and the surface of the substrate 705.

The number, shape, relative positions, and dimensions of the supporting portions are not particularly limited. Where a shadow wall includes a plurality of supporting portions, the shapes and dimensions of the supporting portions may be independently selected.

The inclusion of a hanging portion is optional. Any number of hanging portions may be present, and the shape and dimensions of the hanging portion(s) may be selected as desired.

By selecting the shape and dimensions of the shadow wall, the distance from the shadow wall to the semiconductor component, and the direction of the beam of material being deposited, different patterns of material may be deposited onto the substrate. For example, material arriving from a relatively shallow angle may pass through the gap underneath the hanging portion 720 and may arrive at a position on the substrate which are inaccessible to material applied from a steeper angle which would be blocked by the hanging portion 720.

A shadow wall having a supporting portion and a hanging portion may be fabricated by a two phase process. The first stage involves forming a mask for defining the shapes of the supporting portions of the shadow wall. The second stage forms the shadow wall, using the mask.

The first phase comprises forming a first resist on the substrate. A portion of the first resist is selectively exposed, and then developed to form a mask defining a channel.

The first resist may be an electron beam resist, and preferably a positive electron beam resist. A positive electron beam resist is one which becomes more soluble in a developer solvent once exposed to an electron beam. Examples of positive electron beam resists include acrylate polymers and copolymers. For example, the positive electron beam resist may be a poly(methylmethacrylate), a methylmethacrylate-methacrylic acid copolymer, or a copolymer of chloromethyl methacrylate and methylstyrene. Copolymers of chloromethyl methacrylate and methylstyrene are commercially available under the trade name CSAR. In particular, the first resist may be a poly(methylmethacrylate), PMMA.

The exposure and development conditions may be selected as appropriate based on the resist chosen. For example, where the first resist comprises a poly(methylmethacrylate), a developer comprising a mixture of methyl isobutyl ketone and isopropyl alcohol may be used.

In the second phase, a second resist is formed in the channel, and over the mask. The first resist and the second resist comprise different materials. Exposing portions of the second resist converts those portions into the shadow wall.

The second resist may be selected such that the shadow wall will comprise an inorganic material. The second resist may, for example, comprise a silsesquioxane such as hydrogen silsesquioxane ("HSQ") or methyl silsesquioxane ("MSQ"). Exposing an HSQ to an electron beam converts the HSQ into a silicon oxide.

The second resist may be developed using a developer which does not attack the mask. In an example where the first resist comprises an acrylate polymer or copolymer such as a poly(methylmethacrylate), the developer for the second resist may comprise a base. The base may comprise a base, for example tetramethylammonium hydroxide ("TMAH"), potassium hydroxide or sodium hydroxide. Various developers are commercially available. Illustrative TMAH-based developers are available under the trade names MF-321 and MF-322.

The mask may then be removed to yield the shadow wall. Removing the mask may comprise stripping the first resist. Any appropriate technique for resist stripping may be used, provided that the shadow wall remains intact. Examples include the use of a solvent in combination with critical point drying, or the use of an oxygen plasma. In implementations where a poly(methylmethacrylate) is used as the first resist, the solvent may be acetone, for example.

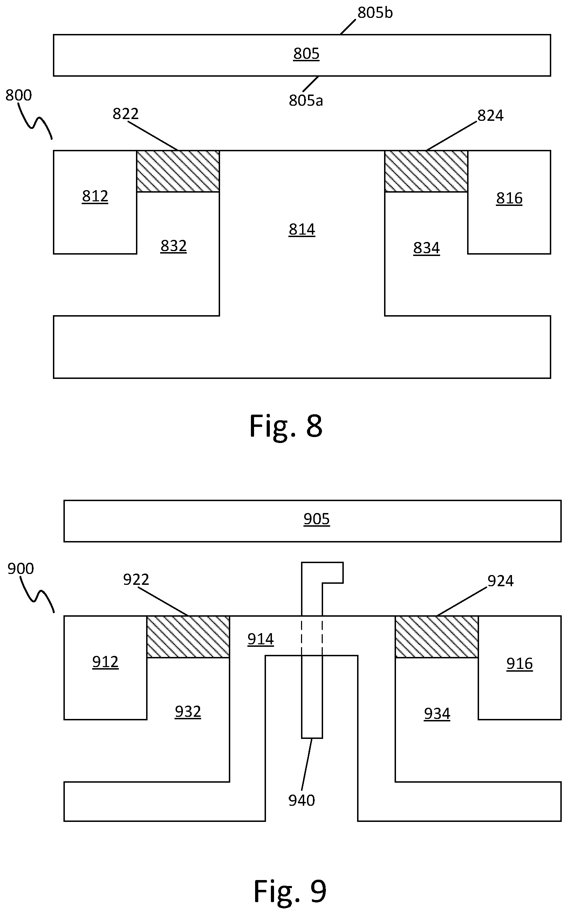

Illustrative arrangements of shadow walls useful for fabricating devices of the type described herein are illustrated in Figs. 8 to 10. Figs. 8 to 10 are schematic plan views showing shadow walls arranged relative to semiconductor nanowires. As will be appreciated, Figs. 8 to 10 are schematic. The shapes, sizes, and position of the various parts of the illustrated shadow wall may each be independently varied.

Fig. 8 shows an example arrangement of shadow walls useful for fabricating a device having a superconductor component in the form of an island, and including a pair of leads at respective ends of the semiconductor-superconductor hybrid structure. Fig. 8 shows a shadow wall 812, 814, 816, 822, 824 arranged relative to a nanowire 805.

The shadow wall in this example is a unitary structure, including a left supporting portion 812, a middle supporting portion 814, and a right supporting portion 816. The left and right supporting portions 812, 126 are connected to the middle supporting portion 814 by respective hanging portions 822, 824. Spaces 832, 834 are provided between the supporting portions.

The distance between each part of the shadow wall and the nanowire may be independently selected. For example, the distance between left supporting portion 814 and nanowire 805 may be different from the distance between hanging portion 822 and nanowire 805.

In use, to fabricate the superconductor component of the hybrid structure, superconductor material is directed towards nanowire 805 from a first angle selected such that the shadow walls shadow a region in front of the nanowire, but do not shadow the front side 805a of the nanowire 805. The nanowire is "self-shadowing": the front side 805a of the nanowire shadows the back side 805b of the nanowire, such that superconductor material arrives at a subset of the facets of the nanowire, as illustrated in Fig. 5.

As will be appreciated, the nanowire may be prepared either before or after forming the shadow walls.

To fabricate the conductive lead, a beam of material is directed toward the nanowire 805 from a second angle which is shallower than the first angle. The supporting portions 812, 814, 816 block the beam, however the beam is able to pass underneath portions 822, 824 thereby depositing on the nanowire and forming the conductive leads.

Material is also deposited in the spaces 832, 834 between the supporting portions 812 and 814, and 814 and 816. The material deposited in these regions may act as transmission lines for connecting the lead to further components. In the case of the superconductor component, the hanging portions 822 and 824 will cast shadows that prevent formation of a continuous strip of superconductor which extends from nanowire 805 to spaces 832, 834. The lead will not connect electrically to the superconductor component, since a tunnel barrier is formed over the superconductor component before depositing the lead. Thus, a superconductive island, not connected electrically to further components, may be formed on the nanowire using this arrangement of shadow walls. Devices having superconductive islands are useful for constructing topological qubits.

Fig. 9 shows an alternative arrangement of shadow walls. The Fig. 9 example differs from the Fig. 8 example by including a metal contact 940 which extends under the middle shadow wall 914. Such a contact 940 is useful for connecting the middle of the superconductor component to ground. Devices in which the superconductor component is connected to ground are useful for performing nonlocal conductance measurements.

Like the Fig. 8 example, the Fig. 9 example includes a shadow wall which is a unitary structure, including a left supporting portion 912, a middle supporting portion 914, and a right supporting portion 916. The left and right supporting portions 912, 916 are connected to the middle supporting portion 914 by respective hanging portions 922, 924. Spaces 932, 934 are provided between the supporting portions.

A metal contact 940 is provided on the substrate. The contact may be formed on the substrate before fabricating the semiconductor component. This may allow for the use of etching to pattern the metal contact 940, without risking damage to the semiconductor-superconductor hybrid structure. The metal contact is fabricated before forming the shadow wall, and extends under middle supporting portion 914.

The arrangement of shadow walls may be modified as appropriate, depending on the desired configuration of the semiconductor-superconductor hybrid structure and the arrangement of leads. The illustrated examples include a single semiconductor-superconductor hybrid structure, however devices which incorporate a plurality of such structures are also contemplated. For example, a topological qubit device may include a plurality of hybrid structures arranged in a network.

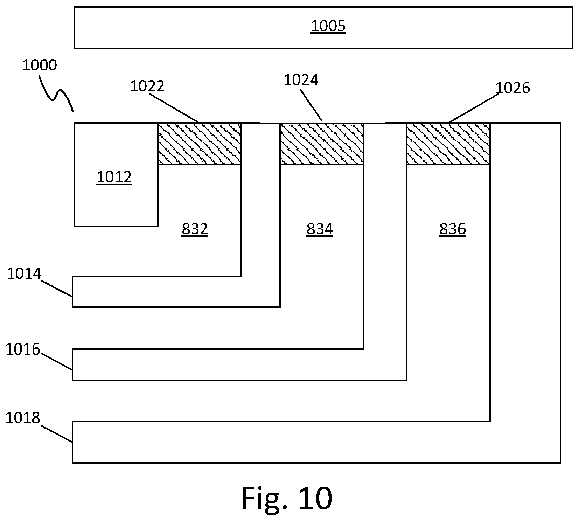

A further example arrangement of shadow walls is illustrated in Fig. 10. The position of a nanowire 1005 is also shown. The Fig. 10 example is useful for fabricating a device having a conductive lead at each end of a topological segment, and a conductive lead in communication with the bulk of the topological segment.

The shadow walls of this example include four supporting portions 1012, 1014, 1016, 1018. Pairs of adjacent shadow supporting portions are connected by hanging portions 1022, 1024, 1026. Spaces 832, 834, 836 are also provided between the pairs of adjacent supporting portions for accommodating the conductive leads.

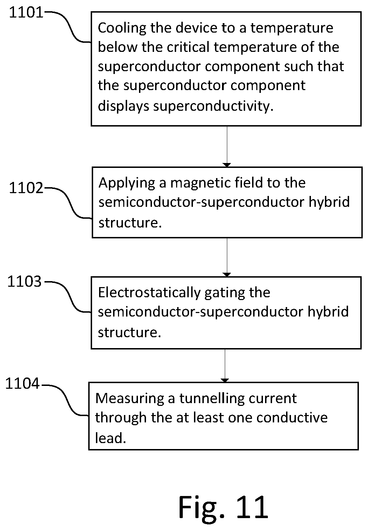

A method of operating a device as provided herein will now be described with reference to Fig. 11. Fig. 11 shows a flow diagram outlining the method.

At block 1101, the device is cooled to an operating temperature below the critical temperature of the superconductor component, such that the superconductor component displays superconductivity. Typically, the device is operated at a temperature of less than 1 K. Various suitable cryogenic systems, e.g. dilution refrigerators, have been described. The device is maintained at the operating temperature during operation.

At block 1102, a magnetic field is applied to the semiconductor-superconductor hybrid structure. Applying a magnetic field lifts spin degeneracy in the device. In other words, different spin states which have the same energy in the absence of a magnetic field are caused to adopt different energy levels.

In implementations where the semiconductor component is in the form of a nanowire, the magnetic field generally includes a component applied parallel to the nanowire. The magnetic field may have a field strength parallel to the nanowire of the order of 1 to 2 T. In implementations where the at least one conductive lead is formed of a superconductor material and extends in a direction perpendicular to the nanowire, the magnetic field may cause the conductive lead to act as a normal conductor.

The magnetic field is typically applied using an external electromagnet. Alternatively or additionally, the device may include a ferromagnetic insulator component for applying a magnetic field internally. The ferromagnetic insulator component may be arranged between the superconductor component and the semiconductor component. Examples of materials useful for forming ferromagnetic insulator components include EuS, EuO, GdN, Y₃Fe₅O₁₂, Bi₃Fe₅O₁₂, YFeO₃, Fe₂O₃, Fe₃O₄, Sr₂CrReO₆, CrBr₃/CrI₃, and YTiO₃. Ferromagnetic insulator components for semiconductor-superconductor hybrid devices are described in e.g. WO 2021/110274 A1.

At block 1103, the semiconductor-superconductor hybrid structure is electrostatically gated. Electrostatic gating may modify the number of available charge carriers in the semiconductor component, and may tune the behaviour of the device. Different portions of the device may be subjected to different electrostatic fields as desired. The electrostatic fields may be applied using appropriate gate electrodes.

At block 1104, a tunnelling current through the at least one conductive lead is measured. This operation may include measuring the frequency, amplitude and/or phase of an alternating current through the at least one conductive lead. An amplifier circuit connected to conductive lead may be used to increase the strength of the signal. Measurements of the tunnelling current may be useful for, for example, readout of data in implementations where the device is a component of a topological qubit.

In implementations where the device includes more than one conductive lead, measurements may be taken at any number of the conductive leads. For example, by measuring tunnelling currents through a pair of conductive leads arranged at respective ends of a semiconductor-superconductor hybrid structure, measurement of a non-local conductance through the semiconductor-superconductor hybrid structure may be made possible.

The measurements are performed while the device is at is operating temperature, and while applying the magnetic field and the electrostatic fields. The strength and/or direction of the magnetic and/or electrostatic fields may be varied.

It will be appreciated that the above embodiments have been described by way of example only.

More generally, according to one aspect of the invention, there is provided a device according to claim 1, comprising: a semiconductor-superconductor hybrid structure comprising a semiconductor component and a superconductor component, the superconductor component comprising a layer of aluminium; at least one conductive lead in tunnelling communication with the semiconductor-superconductor hybrid structure; and a tunnel barrier arranged between the semiconductor-superconductor hybrid structure and the at least one conductive lead. The conductive lead is arranged over the superconductor component such that the superconductor component shields the semiconductor component from the conductive lead. The tunnel barrier is arranged between the superconductor component and the at least one conductive lead. The tunnel barrier consists of a native aluminium oxide layer formed integrally to the superconductor component. Since the superconductor component is arranged between the conductive lead and the semiconductor component, the superconductor component may screen high-energy electrons, thereby allowing low-energy electrons (e.g., those corresponding to MZMs) to be detected more easily. Forming the tunnel barrier integrally to the superconductor component provides a high-quality dielectric barrier between the conductive lead and the semiconductor-superconductor hybrid structure. For example, there may be less contamination in comparison to a device which further includes a deposited, e.g. evaporated, dielectric layer.

The tunnel barrier consists of a native oxide of the aluminium. The tunnel barrier is thus formed integrally with the superconductor component. Using a native oxide, as opposed to a deposited layer, may avoid contamination of the tunnel barrier thereby allowing for improved dielectric properties.

Native oxides may be formed conveniently by exposing the aluminium to an oxidizing gas, particularly dioxygen (O₂), ozone (O₃) or a mixture thereof. The thickness of the native oxide may be controlled by selecting the pressure of the oxidizing gas.

The tunnel barrier may have a thickness in the range 1 to 4 nm, optionally 1 to 2 nm. The superconductor component may have a thickness in the range 6 to 10 nm. The coherence length of the excitations of interest in a semiconductor-superconductor hybrid system is typically of the order of several hundred nanometres, and electrons can readily tunnel through layers of these thicknesses.

The superconductor component comprises a layer of aluminium. Aluminium has been found to be particularly effective at inducing superconductivity in semiconductor materials, especially materials of Formula 1. Further, aluminium oxide may be readily formed on an aluminium layer, and has good chemical and physical stability as well as good dielectric properties.

Typically, the tunnel barrier does not extend beyond the edges of the superconductor component. During fabrication, the tunnel barrier is formed by converting a partial thickness of a superconductor component into a dielectric. Consequently, the tunnel barrier typically does not extend beyond the edges of the superconductor component.

Generally, the at least one conductive lead does not extend over any portion of the semiconductor component which is not covered by the superconductor component and the tunnel barrier. This may allow for more effective shielding of the semiconductor component from the at least one conductive lead by the superconductor component.

The at least one conductive lead may comprise a normally conductive metal. Alternatively, the at least one conductive lead may be formed of the superconductive metal. In such implementations, the at least one conductive lead may be orientated such that the at least one conductive lead has a critical magnetic field lower than that of the superconductor component. The at least one conductive lead generally does not comprise semiconductor material, more particularly electrostatically gated semiconductor material.

The semiconductor component may be in the form of a nanowire. The nanowire may have a diameter in the range 80 to 100 nm and a length in the range 10 to 15 µm. The nanowire may have a plurality of facets. The superconductor component may be arranged over a subset of the plurality of facets. For example, during fabrication, superconductor material may be deposited from a first, exposed, side of the nanowire, and the nanowire may be self-shadowing such that material is not deposited on a second, shadowed, side of the nanowire. In such implementations, the subset is the facets on the exposed side.

Alternatively, the semiconductor component may be a semiconductor heterostructure configured to host a 2-dimensional electron gas or a 2-dimensional hole gas. In such implementations, the device may further comprise one or more gate electrodes configured to define an active channel in the semiconductor heterostructure, and the superconductor component may be arranged over the active channel. The active channel may be in the form of a nanowire.

The device may include a pair of conductive leads, each conductive lead of the pair being in communication with a respective end of the semiconductor-superconductor hybrid structure. Since MZMs exist in pairs, each MZM of the pair being at a respective end of the nanowire, placing leads at the ends of the nanowire may be useful for the detection of MZMs.

The superconductor component may be an island. In such implementations, the superconductor component is not conductively connected to any further component. Devices having superconductive islands may be useful as components of qubit devices.

Alternatively, the superconductor component may be electrically grounded. Grounding the superconductor component may allow the conductive lead to be used to perform tunnelling spectroscopy measurements on the semiconductor-superconductor hybrid structure.

The device may include a conductive lead which is in tunnelling communication with a bulk segment of the semiconductor-superconductor hybrid structure. The superconductor component shields the hybrid structure from electric fields induced by the conductive lead. This may allow conductive leads to be located on bulk segments of the semiconductor-superconductor hybrid stricture without disrupting the topological phase.

Measurements on the bulk of the device, i.e., regions spaced from the ends of the device, may be useful for confirming the presence of MZMs because a topological phase transition, involving bulk gap closing and re-opening, should occur when MZMs are formed. Any number of conductive leads in communication with the bulk may be present.

The semiconductor-superconductor hybrid structure and the at least one conductive lead may be arranged on a substrate. At least one shadow wall may further be arranged on the substrate. The at least one shadow wall may include a supporting portion and a hanging portion. In such implementations, the hanging portion overhangs the substrate and is supported by the supporting portion. Shadow walls are useful for allowing fabrication of metal components, e.g., the superconductor component and conductive lead, without requiring the use of etching. Etching processes can damage or degrade the semiconductor component and/or the interface between the semiconductor component and the superconductor component, and it is desirable to avoid or at least minimize the use of etching during fabrication.

The device may be bottom-gated. A bottom gate and gate dielectric may be formed on the substrate before the semiconductor component and superconductor component are formed. This may minimize the number of fabrication steps to be performed after forming the semiconductor-superconductor hybrid interface, thereby avoiding degradation of the interface.

In another aspect, the present invention provides a method of fabricating a device, according to claim 9. The method comprises: preparing a semiconductor component on a substrate; forming a semiconductor-superconductor hybrid structure by fabricating a superconductor component over the semiconductor component, the superconductor component comprising a layer of aluminium; partially oxidizing the aluminium to form a tunnel barrier consisting of native aluminium oxide on the superconductor component; and fabricating at least one conductive lead on the tunnel barrier. The at least one conductive lead is arranged over the superconductor component such that the superconductor component shields the semiconductor component from the at least one conductive lead. By forming the tunnel barrier *in situ,* a higher quality dielectric may be obtained compared to a method in which the tunnel barrier includes deposited dielectric material.

Forming the tunnel barrier does not include deposition of a layer of dielectric material. The tunnel barrier consists of the compound of the superconductive metal.

The method is used to fabricate a device as described above.

The substrate may be pre-patterned and may include metal components and a dielectric layer covering the metal components. In particular, the substrate may include a pre-patterned gate electrode. The provision of pre-patterned components may allow the number of fabrication operations performed after fabricating the semiconductor-superconductor interface to be minimized.

The tunnel barrier consists of a native oxide of the aluminium. Partially oxidizing the aluminium may comprise exposing the aluminium to a gas comprising dioxygen, ozone, or mixtures thereof. The thickness of the oxide layer may be controlled by selecting the pressure of the gas.

The method may further comprise, before fabricating the superconductor component, fabricating at least one shadow wall on the substrate. Fabricating the superconductor component may comprise directionally depositing the superconductive metal from a first direction selected such that the at least one shadow wall defines a shadow region in which superconductive metal is not deposited. Shadow walls allow for controlled deposition of material, e.g. metal layers, and may allow the device to be fabricated without the use of etching.

The at least one shadow wall may include a supporting portion and a hanging portion. In such implementations, the hanging portion overhangs the substrate and is supported by the supporting portion. Fabricating the at least one conductive lead may comprise directionally depositing conductive material from a second direction, different from the first direction, the second direction being selected such that the at least one shadow wall controls the deposition of the conductive material. By providing a shadow wall with a hanging portion, a single shadow wall may be used to control deposition of both the superconductor component and the at least one conductive lead.

The superconductor component, the tunnel barrier, and the at least one conductive lead may be fabricated without the use of etching. Etching processes such as ion milling can damage or degrade components of the device.

The method may be performed in a sealed apparatus. For example, the semiconductor component and superconductor component may be fabricated in a vacuum chamber, and the oxidation may be performed in a load-lock connected to the vacuum chamber. In such implementations, the substrate is preferably not removed from the apparatus until fabrication of the device is complete. This avoids exposure of the device to the open atmosphere, which may otherwise damage or degrade the surfaces of components.

A still further aspect of the invention provides a method, defined in claim 15, of operating a device of the invention. The method comprises: cooling the device to a temperature below the critical temperature of the superconductor component such that the superconductor component displays superconductivity; applying a magnetic field to the semiconductor-superconductor hybrid structure; electrostatically gating the semiconductor-superconductor hybrid structure; and measuring a tunnelling current through the at least one conductive lead.

This method may be useful in the context of, e.g., reading the state of a topological qubit.

Other variants or use cases of the disclosed techniques may become apparent to the person skilled in the art once given the disclosure herein. The scope of the invention is not limited by the described embodiments but only by the accompanying claims.

## Claims

1. A device (400), comprising:
a semiconductor-superconductor hybrid structure comprising a semiconductor component (410) and a superconductor component (420), the superconductor component (420) comprising a layer of aluminium;
at least one conductive lead (430) in tunnelling communication with the semiconductor-superconductor hybrid structure; and
a tunnel barrier (425) arranged between the semiconductor-superconductor hybrid structure and the at least one conductive lead (430);
wherein the tunnel barrier (425) is arranged between the superconductor component (420) and the at least one conductive lead (430);
**characterized in that:**
the at least one conductive lead (430) is arranged over the superconductor component (420) such that the superconductor component (420) shields the semiconductor component (410) from the at least one conductive lead; and
the tunnel barrier (425) consists of a native aluminium oxide layer formed integrally to the superconductor component (420).

2. The device according to claim 1, wherein the tunnel barrier (425) does not extend beyond the edges of the superconductor component (420).

3. The device according to claim 1 or claim 2, wherein the semiconductor component (410) is in the form of a nanowire.

4. The device according to claim 3, wherein the nanowire has a plurality of facets (411, 412, 413, 414, 415, 416), and the superconductor component (420) is arranged over a subset of the plurality of facets (411, 412, 413, 414, 415, 416).

5. The device according to any preceding claim, wherein the device includes a pair of conductive leads, each conductive lead of the pair being in communication with a respective end of the semiconductor-superconductor hybrid structure; optionally wherein the superconductor component (420) is an island.

6. The device according to any preceding claim, wherein the device includes a conductive lead which is in tunnelling communication with a bulk segment of the semiconductor-superconductor hybrid structure.

7. The device according to any preceding claim, wherein the semiconductor-superconductor hybrid structure and the at least one conductive lead (430) are arranged on a substrate (705),
wherein at least one shadow wall (700) is arranged on the substrate (705);
wherein the at least one shadow wall (700) includes a supporting portion (710a, 710b) and
a hanging portion (720); and
wherein the hanging portion (720) overhangs the substrate (705) and is supported by the supporting portion (710a, 710b).

8. The device according to claim 1, wherein the semiconductor compound is a semiconductor heterostructure configured to host a 2-dimensional electron gas or a 2-dimensional hole gas.

9. A method of fabricating a device (400), which method comprises:
preparing (601) a semiconductor component (410) on a substrate (705);
forming (602) a semiconductor-superconductor hybrid structure by fabricating a superconductor component (420) over the semiconductor component (410), the superconductor component (420) comprising a layer of aluminium;
partially oxidizing (603) the aluminium to form a tunnel barrier (425) on the superconductor component; and
fabricating at least one conductive lead (430) on the tunnel barrier (425),
**characterized in that**:
the tunnel barrier (425) consists of native aluminium oxide; and
the at least one conductive lead (430) is arranged over the superconductor component (420) such that the superconductor component (420) shields the semiconductor component (410) from the at least one conductive lead (430).

10. The method according to claim 9, wherein the substrate includes a pre-patterned gate electrode (940).

11. The method according to claim 9 or claim 10, wherein partially oxidizing (603) the aluminium comprises exposing the aluminium to dioxygen and/or ozone.

12. The method according to any of claims 9 to 11, wherein:
the method further comprises, before fabricating the superconductor component, fabricating at least one shadow wall (700) on the substrate (705); and
fabricating the superconductor component (420) comprises directionally depositing the aluminium from a first direction selected such that the at least one shadow wall (700) defines a shadow region in which superconductive metal is not deposited.

13. The method according to claim 12, wherein:
the at least one shadow wall (700) includes a supporting portion (710a, 710b) and a hanging portion (720);
the hanging portion (720) overhangs the substrate (705) and is supported by the supporting portion (710a, 710b); and
fabricating the at least one conductive lead (430) comprises directionally depositing conductive material from a second direction, different from the first direction, the second direction being selected such that the at least one shadow wall (700) controls the deposition of the conductive material.

14. The method according to any of claims 9 to 13, wherein:
i) the superconductor component (420), the tunnel barrier (425), and the at least one conductive lead (730) are fabricated without the use of etching; and/or
ii) the method is performed in a sealed apparatus, and wherein the substrate (705) is not removed from the apparatus until fabrication of the device is complete.

15. A method of operating a device (400) as defined in any of claims 1 to 8, which method comprises:
cooling (1101) the device (400) to a temperature below the critical temperature of the superconductor component (420) such that the superconductor component (420) displays superconductivity;
applying (1102) a magnetic field to the semiconductor-superconductor hybrid structure;
electrostatically gating (1103) the semiconductor-superconductor hybrid structure; and
measuring (1104) a tunnelling current through the at least one conductive lead (430).

## Patentansprüche

1. Vorrichtung (400), umfassend:
eine Halbleiter-Supraleiter-Hybridstruktur, umfassend eine Halbleiterkomponente (410) und eine Supraleiterkomponente (420), die Supraleiterkomponente (420) umfassend eine Schicht aus Aluminium;
mindestens eine leitfähige Leitung (430), die in Tunnelverbindung mit der Halbleiter-Supraleiter-Hybridstruktur steht; und
eine Tunnelbarriere (425), die zwischen der Halbleiter-Supraleiter-Hybridstruktur und der mindestens einen leitfähigen Leitung (430) angeordnet ist;
wobei die Tunnelbarriere (425) zwischen der Supraleiterkomponente (420) und der mindestens einen leitfähigen Leitung (430) angeordnet ist;
**dadurch gekennzeichnet, dass**:
die mindestens eine leitfähige Leitung (430) so über der Supraleiterkomponente (420) angeordnet ist, dass die Supraleiterkomponente (420) die Halbleiterkomponente (410) vor der mindestens einen leitfähigen Leitung abschirmt; und
die Tunnelbarriere (425) aus einer Schicht aus nativem Aluminiumoxid besteht, die einstückig mit der Supraleiterkomponente (420) ausgebildet ist.

2. Vorrichtung nach Anspruch 1, wobei sich die Tunnelbarriere (425) nicht über die Ränder der Supraleiterkomponente (420) hinaus erstreckt.

3. Vorrichtung nach Anspruch 1 oder 2, wobei die Halbleiterkomponente (410) die Form eines Nanodrahts aufweist.

4. Vorrichtung nach Anspruch 3, wobei der Nanodraht eine Vielzahl von Facetten (411, 412, 413, 414, 415, 416) aufweist und die Supraleiterkomponente (420) über einer Teilmenge der Vielzahl von Facetten (411, 412, 413, 414, 415, 416) angeordnet ist.

5. Vorrichtung nach einem der vorstehenden Ansprüche, wobei die Vorrichtung ein Paar leitfähiger Leitungen einschließt, wobei jede leitfähige Leitung des Paares mit einem jeweiligen Ende der Halbleiter-Supraleiter-Hybridstruktur in Verbindung steht; wobei die Supraleiterkomponente (420) gegebenenfalls eine Insel ist.

6. Vorrichtung nach einem der vorstehenden Ansprüche, wobei die Vorrichtung eine leitfähige Leitung einschließt, die in Tunnelverbindung mit einem Volumenabschnitt der Halbleiter-Supraleiter-Hybridstruktur steht.

7. Vorrichtung nach einem der vorstehenden Ansprüche, wobei die Halbleiter-Supraleiter-Hybridstruktur und die mindestens eine leitfähige Leitung (430) auf einem Substrat (705) angeordnet sind,
wobei mindestens eine Schattenwand (700) auf dem Substrat (705) angeordnet ist;
wobei die mindestens eine Schattenwand (700) einen Stützabschnitt (710a, 710b) einschließt und
ein Aufhängeabschnitt (720); und
wobei der Aufhängeabschnitt (720) über das Substrat (705) hinausragt und von den Stützabschnitten (710a, 710b) gestützt wird.

8. Vorrichtung nach Anspruch 1, wobei die Halbleiterverbindung eine Halbleiterheterostruktur ist, die konfiguriert ist, um ein zweidimensionales Elektronengas oder ein zweidimensionales Lochgas zu beherbergen.

9. Verfahren zum Herstellen einer Vorrichtung (400), wobei das Verfahren Folgendes umfasst:
Vorbereiten (601) einer Halbleiterkomponente (410) auf einem Substrat (705);
Bilden (602) einer Halbleiter-Supraleiter-Hybridstruktur durch Herstellen einer Supraleiterkomponente (420) über der Halbleiterkomponente (410), wobei die Supraleiterkomponente (420) eine Schicht aus Aluminium umfasst;
teilweises Oxidieren (603) des Aluminium, um eine Tunnelbarriere (425) aufder Supraleiterkomponente zu bilden; und
Herstellen mindestens einer leitfähigen Leitung (430) auf der Tunnelbarriere (425),
**dadurch gekennzeichnet, dass**:
die Tunnelbarriere (425) aus reinem Aluminiumoxid besteht; und
die mindestens eine leitfähige Leitung (430) so über der Supraleiterkomponente (420) angeordnet ist, dass die Supraleiterkomponente (420) die Halbleiterkomponente (410) vor der mindestens einen leitfähigen Leitung (430) abschirmt.

10. Verfahren nach Anspruch 9, wobei das Substrat eine vorgestrukturierte Gate-Elektrode (940) einschließt.

11. Verfahren nach Anspruch 9 oder 10, wobei das teilweise Oxidieren (603) des Aluminiums darin besteht, das Aluminium Sauerstoff und/oder Ozon auszusetzen.

12. Verfahren nach einem der Ansprüche 9 bis 11, wobei:
das Verfahren ferner umfasst, dass vor der Herstellung der Supraleiterkomponente mindestens eine Schattenwand (700) auf dem Substrat (705) hergestellt wird; und
die Herstellung der Supraleiterkomponente (420) das gerichtete Aufbringen des Aluminiums aus einer ersten Richtung umfasst, die so gewählt ist, dass die mindestens eine Schattenwand (700) einen Schattenbereich definiert, in dem kein supraleitendes Metall aufgebracht wird.

13. Verfahren nach Anspruch 12, wobei:
die mindestens eine Schattenwand (700) einen Stützabschnitt (710a, 710b) und einen Aufhängeabschnitt (720) einschließt;
der Aufhängeabschnitt (720) über das Substrat (705) hinausraugt und von den Stützabschnitten (710a, 710b) gestützt wird; und
die Herstellung der mindestens einen leitfähigen Leitung (430) das gerichtete Aufbringen von leitfähigem Material aus einer zweiten Richtung umfasst, die sich von der ersten Richtung unterscheidet, wobei die zweite Richtung so gewählt wird, dass die mindestens eine Schattenwand (700) das Aufbringen des leitfähigen Materials steuert.

14. Verfahren nach einem der Ansprüche 9 bis 13, wobei:
i. die Supraleiterkomponente (420), die Tunnelbarriere (425) und die mindestens eine leitfähige Leitung (730) ohne die Verwendung von Ätzverfahren hergestellt werden; und/oder
ii. das Verfahren in einem geschlossenen Gerät durchgeführt wird, wobei das Substrat (705) erst nach Abschluss der Herstellung der Vorrichtung aus dem Gerät entnommen wird.

15. Verfahren zum Betreiben einer Vorrichtung (400) nach einem der Ansprüche 1 bis 8, wobei das Verfahren Folgendes umfasst:
Kühlen (1101) der Vorrichtung (400) auf eine Temperatur unterhalb der kritischen Temperatur der Supraleiterkomponente (420), sodass die Supraleiterkomponente (420) Supraleitung zeigt;
Anlegen (1102) eines Magnetfelds an die Halbleiter-Supraleiter-Hybridstruktur;
elektrostatisches Gating (1103) der Halbleiter-Supraleiter-Hybridstruktur; und
Messen (1104) eines Tunnelstroms durch die mindestens eine leitfähige Leitung (430).

## Revendications

1. Dispositif (400) comprenant :
une structure hybride semi-conducteur-supraconducteur comprenant un composant semi-conducteur (410) et un composant supraconducteur (420), le composant supraconducteur (420) comprenant une couche d'aluminium ;
au moins un fil conducteur (430) en communication par effet tunnel avec la structure hybride semi-conducteur-supraconducteur ; et
une barrière tunnel (425) agencée entre la structure hybride semi-conducteur-supraconducteur et l'au moins un fil conducteur (430) ;
dans lequel la barrière tunnel (425) est agencée entre le composant supraconducteur (420) et l'au moins un fil conducteur (430) ;
**caractérisé en ce que** :
l'au moins un fil conducteur (430) est agencé au-dessus du composant supraconducteur (420) de telle sorte que le composant supraconducteur (420) protège le composant semi-conducteur (410) vis-à-vis de l'au moins un fil conducteur ; et
la barrière tunnel (425) est constituée d'une couche d'oxyde d'aluminium natif formée d'un seul tenant avec le composant supraconducteur (420).

2. Dispositif selon la revendication 1, dans lequel la barrière tunnel (425) ne s'étend pas au-delà des bords du composant supraconducteur (420).

3. Dispositif selon la revendication 1 ou la revendication 2, dans lequel le composant semi-conducteur (410) se présente sous la forme d'un nanofil.

4. Dispositif selon la revendication 3, dans lequel le nanofil a une pluralité de facettes (411, 412, 413, 414, 415, 416), et le composant supraconducteur (420) est agencé sur un sous-ensemble de la pluralité de facettes (411, 412, 413, 414, 415, 416).

5. Dispositif selon l'une quelconque des revendications précédentes, dans lequel le dispositif comporte une paire de fils conducteurs, chaque fil conducteur de la paire étant en communication avec une extrémité respective de la structure hybride semi-conducteur-supraconducteur ; facultativement dans lequel le composant supraconducteur (420) est un îlot.

6. Dispositif selon l'une quelconque des revendications précédentes, dans lequel le dispositif comporte un fil conducteur qui est en communication par effet tunnel avec un segment central de la structure hybride semi-conducteur-supraconducteur.

7. Dispositif selon l'une quelconque des revendications précédentes, dans lequel la structure hybride semi-conducteur-supraconducteur et l'au moins un fil conducteur (430) sont agencés sur un substrat (705), dans lequel au moins une paroi d'ombrage (700) est agencée sur le substrat (705) ;
dans lequel l'au moins une paroi d'ombrage (700) comporte une partie de support (710a, 710b) et
une partie en surplomb (720) ; et
dans lequel la partie en surplomb (720) surplombe le substrat (705) et est soutenue par la partie de support (710a, 710b).

8. Dispositif selon la revendication 1, dans lequel le composé semi-conducteur est une hétérostructure semiconductrice configurée pour abriter un gaz d'électrons bidimensionnel ou un gaz de trous bidimensionnel.

9. Procédé de fabrication d'un dispositif (400), lequel procédé comprend :
la préparation (601) d'un composant semi-conducteur (410) sur un substrat (705) ;
la formation (602) d'une structure hybride semi-conducteur-supraconducteur par fabrication d'un composant supraconducteur (420) sur le composant semi-conducteur (410), le composant supraconducteur (420) comprenant une couche d'aluminium ;
l'oxydation partielle (603) de l'aluminium pour former une barrière tunnel (425) sur le composant supraconducteur ; et
la fabrication d'au moins un fil conducteur (430) sur la barrière tunnel (425),
**caractérisé en ce que** :
la barrière tunnel (425) est constituée d'oxyde d'aluminium natif ; et
l'au moins un fil conducteur (430) est agencé au-dessus du composant supraconducteur (420) de telle sorte que le composant supraconducteur (420) protège le composant semi-conducteur (410) vis-à-vis de l'au moins un fil conducteur (430).

10. Procédé selon la revendication 9, dans lequel le substrat comporte une électrode de grille pré-structurée (940).

11. Procédé selon la revendication 9 ou la revendication 10, dans lequel l'oxydation partielle (603) de l'aluminium comprend l'exposition de l'aluminium à du dioxygène et/ou à de l'ozone.

12. Procédé selon l'une quelconque des revendications 9 à 11, dans lequel :
le procédé comprend en outre, avant la fabrication du composant supraconducteur, la fabrication d'au moins une paroi d'ombrage (700) sur le substrat (705) ; et
la fabrication du composant supraconducteur (420) comprend le dépôt directionnel de l'aluminium à partir d'une première direction choisie de telle sorte que l'au moins une paroi d'ombrage (700) définit une région d'ombre dans laquelle le métal supraconducteur n'est pas déposé.

13. Procédé selon la revendication 12, dans lequel :
l'au moins une paroi d'ombrage (700) comporte une partie de support (710a, 710b) et une partie en surplomb (720) ; la partie en surplomb (720) surplombe le substrat (705) et est soutenue par la partie de support (710a, 710b) ; et
la fabrication de l'au moins un fil conducteur (430) comprend le dépôt directionnel de matériau conducteur à partir d'une seconde direction, différente de la première direction, la seconde direction étant choisie de telle sorte que l'au moins une paroi d'ombrage (700) commande le dépôt du matériau conducteur.

14. Procédé selon l'une quelconque des revendications 9 à 13, dans lequel :
i. le composant supraconducteur (420), la barrière tunnel (425) et l'au moins un fil conducteur (730) sont fabriqués sans l'utilisation d'attaque ; et/ou
ii. le procédé est mis en œuvre dans un appareil scellé, et dans lequel le substrat (705) n'est pas retiré de l'appareil tant que la fabrication du dispositif n'est pas achevée.

15. Procédé de mise en œuvre d'un dispositif (400) selon l'une quelconque des revendications 1 à 8, lequel procédé comprend :
le refroidissement (1101) du dispositif (400) à une température inférieure à la température critique du composant supraconducteur (420) de telle sorte que le composant supraconducteur (420) présente une supraconductivité ;
l'application (1102) d'un champ magnétique à la structure hybride semi-conducteur-supraconducteur ;
la commande électrostatique (1103) de la structure hybride semi-conducteur-supraconducteur ; et
la mesure (1104) d'un courant tunnel à travers l'au moins un fil conducteur (430).
